# FASCICULE DE BREVET EUROPEEN

(11) **EP 0 497 948 B1**
(45) Date de publication et mention de la délivrance du brevet: **03.05.1995**
(21) Numéro de dépôt: 91914937.7
(22) Date de dépôt: 23.08.1991
(51) Int. Cl.: H05K 3/28

(54) **PROCEDE ET DISPOSITIF D'ENCAPSULATION HERMETIQUE DE COMPOSANTS ELECTRONIQUES**
VERFAHREN UND VORRICHTUNG ZUR HERMETISCHEN VERKAPSELUNG VON ELEKTRONISCHEN BAUTEILEN
METHOD AND DEVICE FOR HERMETIC ENCAPSULATION OF ELECTRONIC COMPONENTS

(30) Priorité: 24.08.1990 FR 9010631
(43) Date de publication de la demande: 12.08.1992
(73) Titulaire: THOMSON-CSF, 75008 Paris (FR)
(72) Inventeur: LEROY, Michel, F-78400 Chatou (FR); VAL, Christian, F-78470 S.-Rémy-les-Chevreuses (FR)
(74) Mandataire: Benoit, Monique
(86) Numéro de dépôt international: FR9100688
(87) Numéro de publication internationale: WO9203902

(56) Documents cités:
- EP-A- 0 308 676
- GB-A- 956 001
- US-A- 4 063 349
- US-A- 4 300 184
- IEEE TRANSACTIONS ON PARTS, HYBRIDS AND PACKAGING,vol. PHP 13, No. 3, Septembre 1977, New York,US;pages 273-279; VIDYADHAR S. KALE and T.J. RILEY:"Production parylene coating process for hybrid microcircuits"

## Description

La présente invention a pour objet un dispositif assurant une encapsulation de composants électroniques, encapsulation qui soit hermétique c'est-à-dire qui ne laisse pas passer les gaz et, tout particulièrement, pas la vapeur d'eau.

En effet, ainsi qu'il est connu, le problème de la suppression ou, à défaut, de la limitation de l'humidité dans l'atmosphère entourant les composants électroniques est un problème aigu, voir p. ex. EP-A- 0 308 676.

On sait que le contaminant ayant le rôle le plus important et le plus néfaste sur le plan de la fiabilité d'un composant discret ou d'un circuit intégré est la teneur en eau de l'ambiance environnante. En effet, l'humidité est notamment susceptible de corroder les plots de connexion des circuits elle permet également aux ions de se solubiliser, ce qui renforce la corrosion. Ces effets sont très sensibles sur les circuits intégrés et, ce, que d'autant plus que l'échelle d'intégration est plus élevée, c'est-à-dire que les plots de connexion sont plus petits.

Pour les applications à environnement sévère et hautes performances, telles que les applications militaires ou spatiales, il est connu d'utiliser des boîtiers de composants dont l'embase est en céramique et le capot en métal, scellé hermétiquement sur l'embase, un dégazage avant fermeture du capot étant en outre en général prévu. Un inconvénient de cette solution est son prix de revient, qui est très élevé.

On connaît par ailleurs des boîtiers d'encapsulation en matériau plastique, dont le coût est beaucoup plus bas mais qui présentent l'inconvénient de n'être pas hermétiques.

La présente invention a pour objet une encapsulation de composants électroniques qui soit à la fois hermétique, simple de mise en oeuvre et peu onéreuse.

A cet effet, les composants (tels que pastilles de semiconducteur) sont recouverts :
- d'une première couche d'un matériau organique, relativement épaisse, qui nivelle sensiblement les reliefs et adoucit les angles du composant ;
- d'une deuxième couche d'un matériau minéral, qui peut être beaucoup plus fine, qui assure l'herméticité de l'ensemble.

Ce procédé s'applique aux composants pris individuellement comme aux composants (éventuellement déjà encapsulés) montés sur une carte de circuit imprimé : il est alors appliqué à l'ensemble carte et composants.

De la sorte, les pastilles peuvent être montées aisément sur la carte par l'intermédiaire de leurs boîtiers et, ce, de toute façon connue, à l'aide de matériaux (boîtiers et carte imprimée) peu onéreux ; l'herméticité est assurée par la deuxième couche et l'ensemble est d'un coût relativement faible d'une part, du fait du choix des matériaux (boîtiers et/ou carte imprimée) et, d'autre part, du fait que cette technique est directement applicable à toute carte portant un circuit électronique, sans nécessiter la réimplantation des composants, en vue par exemple de ménager un espace pour des moyens assurant l'étanchéité.

D'autres objets, particularités et résultats de l'invention ressortiront de la description suivante, donnée à titre d'exemple non limitatif et illustrée par les dessins annexés, qui représentent :
- la figure 1, un mode de réalisation du dispositif selon l'invention ;
- la figure 2, les différentes étapes d'un mode de réalisation du procédé selon l'invention.

Sur ces différentes figures, d'une part les mêmes références se rapportent aux mêmes éléments et, d'autre part, l'échelle réelle n'est pas respectée pour la clarté de l'exposé.

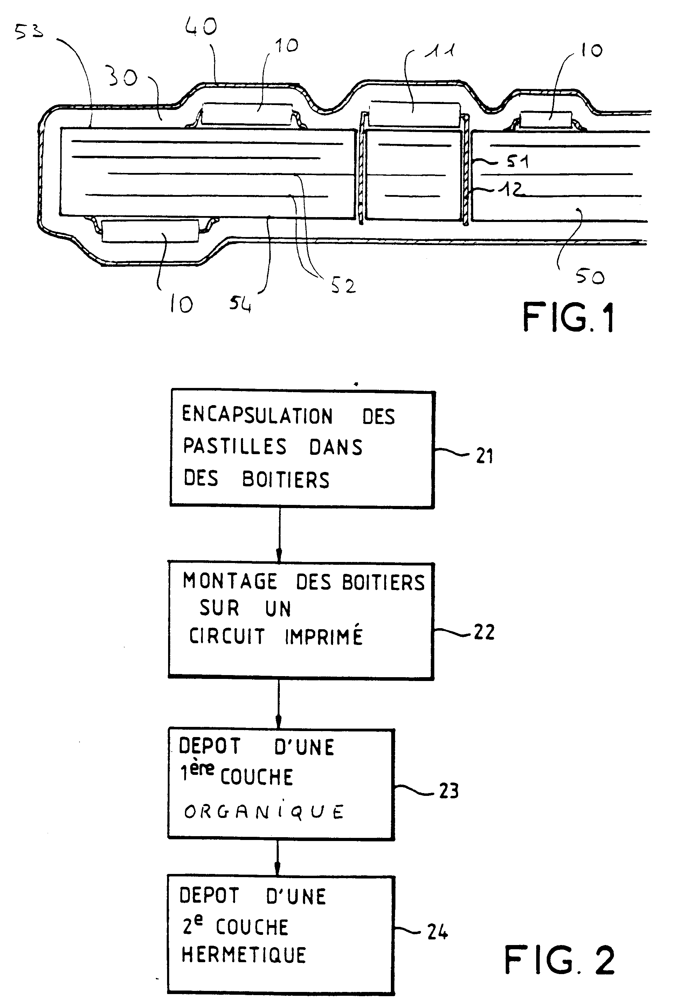

La figure 1 représente donc un mode de réalisation du dispositif selon l'invention et sera décrite en relation avec la figure 2, qui illustre les différentes étapes de sa fabrication.

Dans ce mode de réalisation, des composants électroniques, tels que des pastilles semiconductrices formant des composants discrets ou des circuits intégrés, sont classiquement encapsulés dans les boîtiers (étape 21, figure 2) mais l'herméticité étant assurée par ailleurs, les boîtiers de composant n'ont pas eux-mêmes à être hermétiques ; on peut ainsi utiliser n'importe quel type de boîtier, par exemple des boîtiers plastiques dont on sait que le coût est très nettement inférieur à celui des boîtiers céramiques. Selon l'invention également, on peut utiliser soit des boîtiers destinés à être montés à plat, de tels boîtiers étant repérés 10 sur la figure 1, soit des boîtiers munis de pattes (ou broches) de connexion, boîtiers repérés 11 sur la figure 1, avec des pattes 12, destinées à traverser la carte de circuit imprimé sur laquelle ils sont montés.

Dans une deuxième étape, repérée 22 sur la figure 2, on procède également classiquement au montage des boîtiers précédents sur un substrat (ou carte) de circuit imprimé, repéré 50 sur la figure 1. Selon l'invention et comme précédemment, il est possible d'utiliser n'importe quel type de circuit imprimé, céramique ou époxy, simple couche ou multicouche, simple face ou double face, et dont la taille n'est pas limitée. Sur la figure, on a représenté par exemple une carte multicouche comportant une pluralité de plans de connexion internes, repérés 52, et double face, les composants 10 et/ou 11 étant disposés à la fois sur la face supérieure (53) et sur la face inférieure (54) de la carte 50. En outre, le substrat de circuit imprimé 50 comporte des trous métallisés 51 pour ceux des boîtiers (11) qui comportent des pattes de connexion (12).

L'étape suivante (23 sur la figure 2) consiste à déposer sur sensiblement l'ensemble du circuit imprimé et des boîtiers 10 et 11 une première couche 30, constituée par un composé organique. A titre d'exemple, un matériau connu sous le nom de PARYLENE produit par la Société UNION CARBIDE convient. Un vernis, silicone, époxy ou acrylique, convient également. Sa fonction est de sensiblement planer la surface sur laquelle sera déposée la couche suivante ; on entend ici par planer, réaliser un certain adoucissement des angles ainsi qu'un certain nivellement de la surface et un colmatage des interstices (notamment entre composants 10 ou 11 et surface du circuit imprimé 50), pour former une surface sensiblement uniforme facilitant le dépôt de la couche suivante et autorisant pour cette dernière, une épaisseur très faible sans risque de craquelures. A cet effet, cette première couche a de préférence une épaisseur relativement importante (typiquement quelques dizaines de microns).

L'étape suivante (24 sur la figure 2) consiste à déposer sur sensiblement l'ensemble de la couche 30 une deuxième couche, repérée 40, d'un matériau minéral hermétique. Cette couche peut être constituée typiquement par un composé métallique et peut être très fine (typiquement quelques microns) grâce à la présence de la première couche. Le prix de revient du dépôt d'une couche telle que 40 étant plus élevé que celui de la couche 30, ceci constitue un avantage. A titre d'exemple, un oxyde métallique (d'aluminium, de silicium, de zirconium, de titane ou d'étain par exemple) ou un nitrure métallique (nitrure de silicium par exemple) conviennent. Cette couche peut être obtenue soit par dépôt direct du composé métallique, soit par dépôt du métal qui est ensuite oxydé et/ou nitruré, par tout moyen connu. Par ailleurs, dans le cas où le matériau choisi pour réaliser la couche 40 est conducteur de l'électricité, le matériau de la couche 30 devra en outre être isolant électriquement .

Dans une variante de réalisation (non représentée), on dépose, sur la couche minérale 40, une troisième couche de protection mécanique : en effet, si la couche 40 est très mince, il peut être préférable de la protéger contre les chocs ou les rayures. A titre d'exemple, cette troisième couche peut être constituée par une couche mince (typiquement de 5 à 10 »m environ) de PARYLENE.

Selon une autre variante, on dépose, toujours sur la couche 40, une troisième couche d'un matériau organique tel que le PARYLENE, puis une quatrième couche de matériau minéral tel que celui constituant la couche 40 (SiO₂ par exemple) ; les deuxième-quatrième couches forment alors une structure de type sandwich qui présente une tenue mécanique renforcée.

Il est à noter que la présence de la première couche 30 sous la couche 40 permet de plus de dégager facilement en tant que besoin les parties ainsi recouvertes et qui ne devraient pas l'être, tels que éléments réglables ou commutateurs. En outre, elle permet, par usinage local au laser par exemple, de réaliser des trous ponctuels permettant l'application d'une pointe de test, sans compromettre l'étanchéité de l'ensemble de la carte.

Le procédé décrit ci-dessus est utilisable de la même manière pour réaliser l'herméticité d'un boîtier seul, non monté sur une carte de circuit imprimé seule l'étape 22 de la figure 2 est alors supprimée.

L'intérêt en est notamment la réparation d'une carte : dans ce cas, le ou les boîtiers hors service peuvent être remplacés par des boîtiers en plastique par exemple, recouverts des deux couches décrites précédemment avant leur montage sur la carte.

Le procédé selon l'invention est, de la même manière, applicable également pour réaliser la protection hermétique d'un composant individuel, monté ou non sur une carte de circuit imprimé. Dans le deuxième cas, les étapes 21 et 22 de la figure 2 sont supprimées et le composant est directement enrobé des deux couches visées aux étapes 23 et 24, respectivement. Dans le premier cas, l'étape 21 de la figure 2 est supprimée : les composants sont montés sur le circuit imprimé puis recouverts des deux couches précédentes, organique puis minérale.

Il apparaît ainsi que l'invention permet notamment de réaliser l'herméticité des deux faces de n'importe quel circuit monté sur un circuit imprimé, sans nécessiter de modification de celui-ci, d'implantation ou de matériau notamment. Elle permet également une réparation locale sans destruction de l'herméticité du reste du circuit porté par la carte, le ou les composants de remplacement étant également rendus hermétiques par la même méthode. En outre, les couches ainsi déposées étant peu épaisses par rapport à l'épaisseur du circuit lui-même, elles ne forment pas un obstacle à l'évacuation de la chaleur engendrée par le fonctionnement des composants. Enfin, ces différentes couches étant transparentes sous faible épaisseur, les marquages des circuits sont visibles à travers les couches et il n'est pas nécessaire de les reproduire sur la couche extérieure.

## Revendications

1. Procédé d'encapsulation hermétique d'au moins un composant électronique, caractérisé par le fait qu'il comporte :
- une première étape de dépôt sur le composant d'une première couche en un matériau organique, dont l'épaisseur permet de sensiblement planer la surface sur laquelle sera déposée une deuxième couche ;
- une deuxième étape de dépôt de la deuxième couche sur la première couche, en un matériau minéral hermétique.

2. Procédé selon la revendication 1, caractérisé par le fait qu'il comporte en outre, avant la première étape, une première étape supplémentaire d'encapsulation des composants chacun dans un boîtier.

3. Procédé selon la revendication 1, caractérisé par le fait qu'il comporte en outre, avant la première étape, une première étape supplémentaire d'encapsulation des composants chacun dans un boîtier, puis une deuxième étape supplémentaire de montage des boîtiers sur une carte de circuit imprimé et que les première et deuxième couches sont déposées sensiblement sur l'ensemble de la carte et des boîtiers.

4. Procédé selon l'une des revendications précédentes, caractérisé par le fait que la première couche est en outre électriquement isolante.

5. Procédé selon l'une des revendications précédentes, caractérisé par le fait que la deuxième couche est un composé métallique.

6. Procédé selon la revendication 5, caractérisé par le fait que la deuxième couche comporte un oxyde et/ou un nitrure métallique.

7. Procédé selon la revendication 6, caractérisé par le fait que la deuxième couche est obtenue par dépôt d'un métal puis oxydation et/ou nitruration du métal.

8. Procédé selon l'une des revendications précédentes, caractérisé par le fait qu'il comporte en outre, après la deuxième étape, une troisième étape de dépôt sur la deuxième couche d'une troisième couche de protection mécanique.

9. Procédé selon l'une des revendications 1 à 7, caractérisé par le fait qu'il comporte en outre, après la deuxième étape, une troisième étape de dépôt sur la deuxième couche d'une troisième couche d'un matériau organique puis d'une quatrième couche d'un matériau minéral.

10. Dispositif d'encapsulation hermétique de composants électroniques, comportant des boîtiers enfermant chacun des composants et une carte de circuit imprimé sur laquelle sont montés les boîtiers, le dispositif comportant en outre :
- une première couche d'un matériau organique, recouvrant sensiblement l'ensemble de la carte et des boîtiers ; et étant caractérisé par le fait qu'il comporte une deuxième couche hermétique d'un matériau minéral, recouvrant la première couche.

11. Dispositif selon la revendication 10, caractérisé par le fait que la première couche d'enrobage est constituée de PARYLENE ou de vernis.

12. Dispositif selon l'une des revendications 10 ou 11, caractérisé par le fait que la deuxième couche d'enrobage comporte un oxyde d'aluminium, de silicium, de zirconium, de titane ou d'étain.

13. Dispositif selon l'une des revendications 10 ou 11, caractérisé par le fait que la deuxième couche d'enrobage comporte du nitrure de silicium.

## Patentansprüche

1. Verfahren zur hermetischen Verkapselung wenigstens eines elektronischen Bauteils, dadurch gekennzeichnet, daß es folgende Schritte aufweist:
- einen ersten Schritt des Aufbringens einer ersten Schicht aus einem organischen Material auf dem Bauteil, deren Dicke es erlaubt, die Fläche im wesentlichen zu glätten, auf der eine zweite Schicht aufgebracht wird;
- einen zweiten Schritt des Aufbringens der zweiten Schicht aus einem hermetischen mineralischen Material auf der ersten Schicht.

2. Verfahren nach Anspruch 1, dadurch gekennzeichnet, daß es ferner vor dem ersten Schritt einen ersten zusätzlichen Schritt der Verkapselung der Bauteile in jeweils einem Gehäuse aufweist.

3. Verfahren nach Anspruch 1, dadurch gekennzeichnet, daß es ferner vor dem ersten Schritt einen ersten zusätzlichen Schritt der Verkapselung der Bauteile in jeweils einem Gehäuse sowie dann einen zweiten zusätzlichen Schritt der Montage der Gehäuse auf einer Leiterplatte aufweist, und daß die erste und die zweite Schicht im wesentlichen auf der Gesamtheit der Platte und der Gehäuse aufgebracht sind.

4. Verfahren nach einem der vorhergehenden Ansprüche, dadurch gekennzeichnet, daß die erste Schicht ferner elektrisch isolierend ist.

5. Verfahren nach einem der vorhergehenden Ansprüche, dadurch gekennzeichnet, daß die zweite Schicht aus einer Metallverbindung besteht.

6. Verfahren nach Anspruch 5, dadurch gekennzeichnet, daß die zweite Schicht ein Metalloxid und/oder -nitrid aufweist.

7. Verfahren nach Anspruch 6, dadurch gekennzeichnet, daß die zweite Schicht durch Aufbringen eines Metalls und dann durch die Oxidation und/oder Nitrierung des Metalls erhalten ist.

8. Verfahren nach einem der vorhergehenden Ansprüche, dadurch gekennzeichnet, daß es ferner nach dem zweiten Schritt einen dritten Schritt des Aufbringens einer dritten mechanischen Schutzschicht auf der zweiten Schicht aufweist.

9. Verfahren nach einem der Ansprüche 1 bis 7, dadurch gekennzeichnet, daß es ferner nach dem zweiten Schritt einen dritten Schritt des Aufbringens einer dritten Schicht aus einem organischen Material und dann einer vierten Schicht aus einem mineralischen Material auf der zweiten Schicht aufweist.

10. Vorrichtung zur hermetischen Verkapselung von elektronischen Bauteilen mit Gehäusen, die jeweils Bauteile umschließen, sowie einer Leiterplatte, auf der die Gehäuse montiert sind, wobei die Vorrichtung ferner folgendes aufweist:
- eine erste Schicht aus einem organischen Material, die im wesentlichen die Gesamtheit der Platte und der Gehäuse überdeckt,
und wobei sie dadurch gekennzeichnet ist, daß sie eine zweite hermetische Schicht aus einem mineralischen Material aufweit, die die erste Schicht überdeckt.

11. Vorrichtung nach Anspruch 10, dadurch gekennzeichnet, daß die erste Einbettungsschicht aus PARYLEN oder Lack gebildet ist.

12. Vorrichtung nach einem der Ansprüche 10 oder 11, dadurch gekennzeichnet, daß die zweite Einbettungsschicht ein Aluminium-, Silicium-, Zirconium-, Titan- oder Zinnoxid auweit.

13. Vorrichtung nach einem der Ansprüche 10 oder 11, dadurch gekennzeichnet, daß die zweite Einbettungsschicht Siliciumnitrid aufweist.

## Claims

1. Process for hermetic encapsulation of at least one electronic component, characterized in that it comprises:
- a first step of deposition on the component of a first layer made of an organic material whose thickness makes it possible substantially to smooth the surface on which a second layer will be deposited;
- a second step of deposition of the second layer on the first layer, made of a hermetic inorganic material.

2. Process according to Claim 1, characterized in that it additionally comprises, before the first step, an additional first step of encapsulation of the components, each in a package.

3. Process according to Claim 1, characterized in that it additionally comprises, before the first step, an additional first step of encapsulation of the components, each in a package, then a second additional step of mounting of the packages on a printed circuit board and that the first and second layers are deposited substantially over the whole of the board and of the packages.

4. Process according to one of the preceding claims, characterized in that the first layer is additionally electrically insulating.

5. Process according to one of the preceding claims, characterized in that the second layer is a metal compound.

6. Process according to Claim 5, characterized in that the second layer comprises a metal oxide and/or nitride.

7. Process according to Claim 6, characterized in that the second layer is obtained by deposition of a metal followed by oxidation and/or nitriding of the metal.

8. Process according to one of the preceding claims, characterized in that it additionally comprises, after the second step, a third step of deposition of a third layer on the second layer, for mechanical protection.

9. Process according to one of Claims 1 to 7, characterized in that it additionally comprises, after the second step, a third step of deposition of a third layer of an organic material on the second layer and then of a fourth layer of an inorganic material.

10. Device for hermetic encapsulation of electronic components, comprising packages, each enclosing components, and a printed circuit board on which the packages are mounted, the device additionally comprising:
- a first layer of an organic material covering substantially the whole of the board and of the packages;
and being characterized in that it comprises a second hermetic layer of an inorganic material covering the first layer.

11. Device according to Claim 10, characterized in that the first coating layer consists of Parylene or of varnish.

12. Device according to either of Claims 10 and 11, characterized in that the second coating layer comprises an aluminium, silicon, zirconium, titanium or tin oxide.

13. Device according to either of Claims 10 and 11, characterized in that the second coating layer comprises silicon nitride.
